# EUROPÄISCHE PATENTSCHRIFT

(11) **EP 1 257 058 B1**
(45) Veröffentlichungstag und Bekanntmachung des Hinweises auf die Patenterteilung: **04.04.2018**
(21) Anmeldenummer: 02009944.6
(22) Anmeldetag: 03.05.2002
(51) Int. Cl.: H03K 19/0185, H03K 5/08, H04L 25/06, H03K 5/003

(54) **Anordnung und Verfahren zur Ermittlung des jeweils aktuellen Pegels eines digitalen Signals**
Device and method for determining the present logic level of a digital signal
Dispositif et procédé pour déterminer le niveau logique actuel d'un signal numérique

(30) Priorität: 07.05.2001 DE 10122023
(43) Veröffentlichungstag der Anmeldung: 13.11.2002
(73) Patentinhaber: Infineon Technologies AG, 85579 Neubiberg (DE)
(72) Erfinder: Christoph, Axel, 6410 Telfs (AT); Kahr, Viktor, 8075 Hart bei Graz (AT); Reithofer, Axel, 8020 Graz (AT); Panhofer, Harald, 8020 Graz (AT)
(74) Vertreter: Repkow, Ines

(56) Entgegenhaltungen:
- EP-A2- 0 063 443
- DE-U- 9 319 428
- DE-U- 20 100 422
- FR-A- 2 720 575
- US-A- 4 433 256
- US-A- 5 933 455
- US-A- 5 949 257
- ANONYMOUS: "On chip clock receiver circuit" RESEARCH DISCLOSURE, KENNETH MASON PUBLICATIONS, HAMPSHIRE, GB, Bd. 309, Nr. 32, Januar 1990 (1990-01), XP007114609 ISSN: 0374-4353
- PATENT ABSTRACTS OF JAPAN Bd. 0051, Nr. 92 (E-085), 8. Dezember 1981 (1981-12-08) & JP 56 115023 A (NEC CORP), 10. September 1981 (1981-09-10)

## Beschreibung

Die vorliegende Erfindung betrifft eine Vorrichtung gemäß dem Oberbegriff der Patentanspruchs 1 und ein Verfahren gemäß dem Oberbegriff des Patentanspruchs 29.

Anordnungen und Verfahren zur Ermittlung des jeweils aktuellen Pegels eines digitalen Signals werden insbesondere benötigt, um den jeweils aktuellen Pegel eines digitalen Signals zu ermitteln, bei welchem der den niedrigen Pegel repräsentierende Signalzustand und/oder der den hohen Pegel repräsentierende Signalzustand nicht oder nicht genau bekannt sind und/oder sich verändern können.

Digitale Signale, bei welchen dies der Fall ist, sind beispielsweise die Ausgangssignale von als aktive Drehzahlsensoren verwendeten Hallsensoren. Verantwortlich für die genannten Unsicherheiten sind beispielsweise Fertigungsstreuungen oder Temperaturabhängigkeiten.

Die Ermittlung des jeweils aktuellen Pegels eines digitalen Signals erfolgt üblicherweise unter Verwendung eines Schwellenwertes, welcher zwischen dem den hohen Pegel repräsentierenden Zustand des digitalen Signals und dem den niedrigen Pegel repräsentierenden Zustand des digitalen Signals liegt. Dann kann der jeweils aktuelle Pegel des digitalen Signals einfach durch einen Vergleich des digitalen Signals mit dem Schwellenwert ermittelt werden: dabei wird davon ausgegangen, daß das digitale Signal den hohen Pegel aufweist, wenn und so lange das digitale Signal größer als der Schwellenwert ist, und daß das digitale Signal den niedrigen Pegel aufweist, wenn und so lange das digitale Signal kleiner als der Schwellenwert ist (oder umgekehrt).

Würde man versuchen, den jeweils aktuellen Pegel eines digitalen Signals, von welchem der den niedrigen Pegel repräsentierende Signalzustand und/oder der den hohen Pegel repräsentierende Signalzustand nicht oder nicht genau bekannt sind und/oder sich verändern können, unter Verwendung eines fest eingestellten Schwellenwertes zu ermitteln, so bestünde eine große Wahrscheinlichkeit, daß der gewählte Schwellenwert nicht optimal ist, genauer gesagt näher (zu nahe) bei dem den hohen Pegel repräsentierenden Zustand des digitalen Signals liegt, oder näher (zu nahe) bei dem den niedrigen Pegel repräsentierenden Zustand des digitalen Signals liegt.

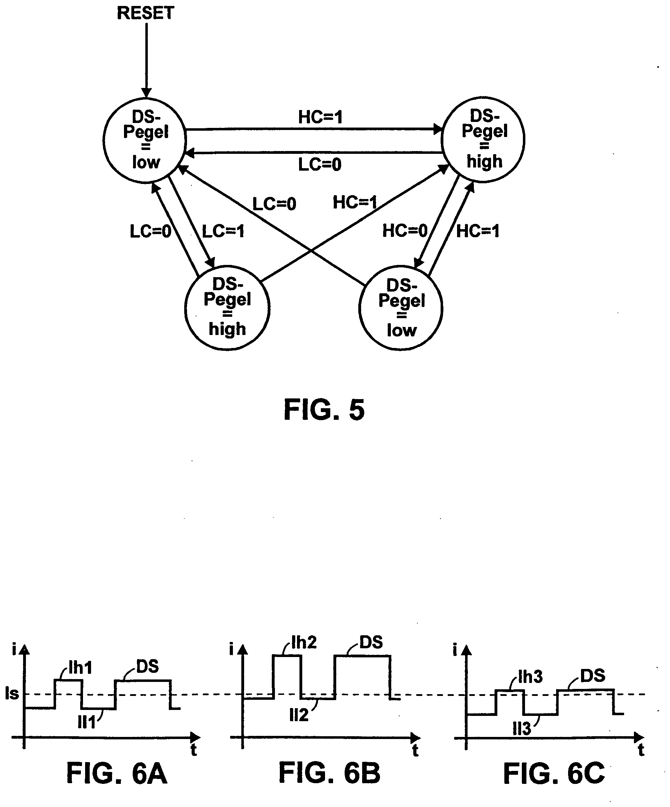

Dies ist beispielhaft in den Figuren 6A, 6B und 6C veranschaulicht.

In den Figuren 6A bis 6C sind die Stromverläufe von zu verschiedenen Zeitpunkten aus einem Hallsensor ausgegebenen digitalen Signalen DS oder von aus verschiedenen Hallsensoren des gleichen Typs ausgegebenen digitalen Signalen DS dargestellt.

Bei dem in der Figur 6A gezeigten digitalen Signal ist der den niedrigen Pegel des digitalen Signals DS repräsentierende Strom ein Strom Il1, und der den hohen Pegel des digitalen Signals DS repräsentierende Strom ein Strom Ih1; bei dem in der Figur 6B gezeigten digitalen Signal ist der den niedrigen Pegel des digitalen Signals DS repräsentierende Strom ein Strom I12, und der den hohen Pegel des digitalen Signals DS repräsentierende Strom ein Strom Ih2; bei dem in der Figur 6C gezeigten digitalen Signal ist der den niedrigen Pegel des digitalen Signals DS repräsentierende Strom ein Strom I13, und der den hohen Pegel des digitalen Signals DS repräsentierende Strom ein Strom Ih3. Wie aus den Figuren ersichtlich ist, sind sowohl die die niedrigen Pegel der digitalen Signale repräsentierenden Ströme Il1, Il2 und Il3, als auch die die hohen Pegel der digitalen Signale repräsentierenden Ströme Ih1, Ih2 und Ih3 unterschiedlich groß.

Möchte man die jeweils aktuellen Pegel der digitalen Signale unter Verwendung eines konstanten Schwellenwertes, genauer gesagt unter Verwendung eines konstanten Schwellenstromes Is ermitteln, so führt dies im Fall von Figur 6A zu einem optimalen Ergebnis. In diesem Fall liegt der Schwellenstrom Is genau in der Mitte zwischen Il1 und Ih1, wodurch auch dann, wenn das digitale Signal DS von Störungen überlagert wird, eine ordnungsgemäße Ermittlung des jeweils aktuellen Pegels des digitalen Signals möglich ist.

Im Fall von Figur 6B liegt der Schwellenstrom Is sehr viel näher bei Il2 als bei Ih2. Die Folge ist, daß dann, wenn das digitale Signal DS von Störungen überlagert wird, ein einen niedrigen Pegel des digitalen Signals repräsentierender Strom den Schwellenstrom Is übersteigen kann, und dadurch als hoher Pegel des digitalen Signals interpretiert werden kann.

Entsprechendes gilt für den in Figur 6C dargestellten Fall: Im Fall von Figur 6C liegt der Schwellenstrom Is sehr viel näher bei Ih3 als bei Il3. Die Folge ist, daß dann, wenn das digitale Signal DS von Störungen überlagert wird, ein einen hohen Pegel des digitalen Signals repräsentierender Strom den Schwellenstrom Is unterschreiten kann, und dadurch als niedriger Pegel des digitalen Signals interpretiert werden kann.

Aus den genannten Gründen erweist es sich als vorteilhaft, wenn man den verwendeten Schwellenwert dynamisch an die jeweils herrschenden Verhältnisse anpaßt.

Dies kann beispielsweise dadurch geschehen, daß der maximale Strom und der minimale Strom des digitalen Signals ermittelt werden, und der Schwellenstrom an eine bestimmte Stelle, beispielsweise in die Mitte zwischen diese Extremwerte gelegt wird. Auch dies ist jedoch nicht frei von Nachteilen. Insbesondere kann der so festgelegte Schwellenstrom stark von dem digitalen Signal überlagerten Störungen beeinflußt sein und mithin weit entfernt von optimalen Schwellenwert liegen.

Eine weitere Möglichkeit zur dynamischen Festlegung des Schwellenwertes besteht darin, daß das digitale Signal einer Tiefpaßfilterung unterzogen wird, und daß das dabei erhaltene Signal als Schwellenwert verwendet wird. Nachteilig hieran ist, daß diese Art der Schwellenwertfestlegung nur für digitale Signale mit einem Tastverhältnis von 50% geeignet ist; für andere Tastverhältnisse stellt das Ergebnis der Tiefpaßfilterung nicht den Mittelwert zwischen dem den hohen Pegel repräsentierenden Strom und dem den niedrigen Pegel repräsentierenden Strom dar, wodurch es als Schwellenwert oder zur Schwellenwertermittlung nicht geeignet ist.

Weiterer Stand der Technik ist aus Dokument EP 0 063 443 bekannt. Darin sind eine Anordnung gemäß dem Oberbegriff des Patentanspruchs 1 und ein Verfahren gemäß dem Oberbegriff des Patentanspruchs 29 beschrieben. Durch diese Anordnung und dieses Verfahren lassen sich die vorstehend angesprochenen Probleme jedoch nicht oder jedenfalls nicht zur vollen Zufriedenheit lösen.

Der vorliegenden Erfindung liegt daher die Aufgabe zugrunde, die Anordnung gemäß dem Oberbegriff des Patentanspruchs 1 und das Verfahren gemäß dem Oberbegriff des Patentanspruchs 29 derart weiterzubilden, daß sich der Pegel eines digitalen Signals auch dann, wenn der den niedrigen Pegel repräsentierende Signalzustand und/oder der den hohen Pegel repräsentierende Signalzustand nicht oder nicht genau bekannt sind und/oder sich verändern können, auf einfache Weise unter allen Umständen zuverlässig fehlerfrei erkennen läßt.

Diese Aufgabe wird erfindungsgemäß durch die in Patentanspruch 1 beanspruchte Anordnung bzw. durch das in Patentanspruch 29 beanspruchte Verfahren gelöst.

Die erfindungsgemäße Anordnung und das erfindungsgemäße Verfahren zeichnen sich dadurch aus, daß die Schwellenwertbestimmungseinrichtung den Schwellenwert unter Berücksichtigung des zeitlichen Verlaufs des digitalen Signals festlegt, genauer gesagt durch Multiplizieren des den niedrigen Pegel oder des den hohen Pegel repräsentierenden Zustandes des digitalen Signals (DS) mit einem bestimmten Faktor ermittelt.

Dadurch ist es beispielsweise möglich, daß der den niedrigen Pegel und/oder den den hohen Pegel repräsentierende Zustand des digitalen Signals ermittelt wird, und der Schwellenwert durch eine Multiplikation des Ergebnisses dieser Ermittlung mit einem bestimmten Faktor festgelegt wird.

Dies wiederum ermöglicht es, den Schwellenwert so festzulegen, daß dieser stets eine vorbestimmte Relativlage bezüglich des den hohen Pegel repräsentierenden Zustandes des digitalen Signals und/oder bezüglich des den niedrigen Pegel repräsentierenden Zustandes des digitalen Signals einnimmt.

Die Ermittlung des den niedrigen Pegel und/oder des den hohen Pegel repräsentierenden Zustandes des digitalen Signals ist beispielsweise durch einen Tiefpaß möglich, der wie in den Ansprüchen 5 bis 16 und 22 bis 33 beansprucht eingesetzt wird, und bereitet keine technischen Schwierigkeiten.

Es wurde mithin eine einfach realisierbare Möglichkeit gefunden, den Schwellenwert so festzulegen, daß sich der Pegel eines digitalen Signals auch dann, wenn der den niedrigen Pegel repräsentierende Signalzustand und/oder der den hohen Pegel repräsentierende Signalzustand nicht oder nicht genau bekannt sind und/oder sich verändern können, zuverlässig fehlerfrei erkennen läßt.

Vorteilhafte Weiterbildungen der Erfindung sind den Unteransprüchen, der folgenden Beschreibung und den Figuren entnehmbar.

Die Erfindung wird nachfolgend anhand von Ausführungsbeispielen unter Bezugnahme auf die Figuren näher erläutert. Es zeigen
- Figur 1: ein erstes Ausführungsbeispiel einer neuartigen Anordnung zur Ermittlung des jeweils aktuellen Pegels eines digitalen Signals,
- Figur 2: ein zweites Ausführungsbeispiel einer neuartigen Anordnung zur Ermittlung des jeweils aktuellen Pegels eines digitalen Signals,
- Figur 3: ein drittes Ausführungsbeispiel einer neuartigen Anordnung zur Ermittlung des jeweils aktuellen Pegels eines digitalen Signals,
- Figur 4: eine Darstellung zur Veranschaulichung der Lage von in der Anordnung gemäß Figur 3 verwendeten Referenzströmen,
- Figur 5: eine Darstellung zur Veranschaulichung der Bestimmung des Ausgangssignals einer in der Anordnung gemäß Figur 3 enthaltenen Logik L, und
- Figur 6: eine Darstellung zur Veranschaulichung der Probleme, die bei einer herkömmlichen Anordnung zur Ermittlung des jeweils aktuellen Pegels eines digitalen Signals auftreten können.

Die im folgenden beschriebenen Anordnungen und Verfahren sind Teil eines Kraftfahrzeug-Steuergerätes, und dienen zur Ermittlung des jeweils aktuellen Pegels eines Signals, das von einem als aktiver Drehzahlsensor verwendeten Hallsensor ausgegeben wird. Es sei jedoch bereits an dieser Stelle darauf hingewiesen, daß durch die im folgenden beschriebenen Anordnungen und Verfahren auch die jeweils aktuellen Pegel beliebiger anderer digitaler Signale ermittelt werden können, von welchen der den niedrigen Pegel repräsentierende Zustand und/oder der den hohen Pegel repräsentierende Zustand nicht oder nicht genau bekannt sind und/oder sich verändern können. Die beschriebenen Anordnungen und Verfahren müssen auch nicht Bestandteil eines Kraftfahrzeug-Steuergerätes sein.

Bei den digitalen Signalen, deren jeweils aktueller Pegel durch die im folgenden beschriebenen Anordnungen und Verfahren ermittelt wird, handelt es sich um Signale, bei welchen unterschiedliche Pegel durch unterschiedlich große Ströme repräsentiert werden. Auf genau die selbe Art und Weise können jedoch auch die jeweils aktuellen Pegel von digitalen Signalen ermittelt werden, bei welche unterschiedliche Pegel als unterschiedlich große Spannungen in Erscheinung treten.

Im betrachteten Beispiel ist der im umzusetzenden digitalen Signal den hohen Pegel repräsentierende Strom um einen bestimmten Faktor größer als der den niedrigen Pegel repräsentierende Strom. Dieser Faktor hängt nicht oder allenfalls unwesentlich von der Größe des den niedrigen Pegel oder des den hohen Pegel repräsentierenden Stromes ab und weist im betrachteten Beispiel den Wert 2 auf; der Faktor könnte prinzipiell aber auch beliebig viel größer oder kleiner sein. Ebenso sind die beschriebenen Anordnungen und Verfahren nach einer entsprechenden Modifikation selbstverständlich auch im Fall anwendbar, daß der im digitalen Signal den hohen Pegel repräsentierende Strom kleiner ist als der den niedrigen Pegel repräsentierende Strom.

Durch die beschriebenen Anordnungen und Verfahren wird das umzusetzende digitale Signal in ein zweites digitales Signal umgesetzt, dessen Strom- und/oder Spannungsverlauf dem Pegelverlauf des umzusetzenden Signals entspricht, und bei welchem der den niedrigen Pegel repräsentierende Strom bzw. die den niedrigen Pegel repräsentierende Spannung, und der den hohen Pegel repräsentierende Strom bzw. die den hohen Pegel repräsentierende Spannung definierte und nicht schwankende Werte aufweisen.

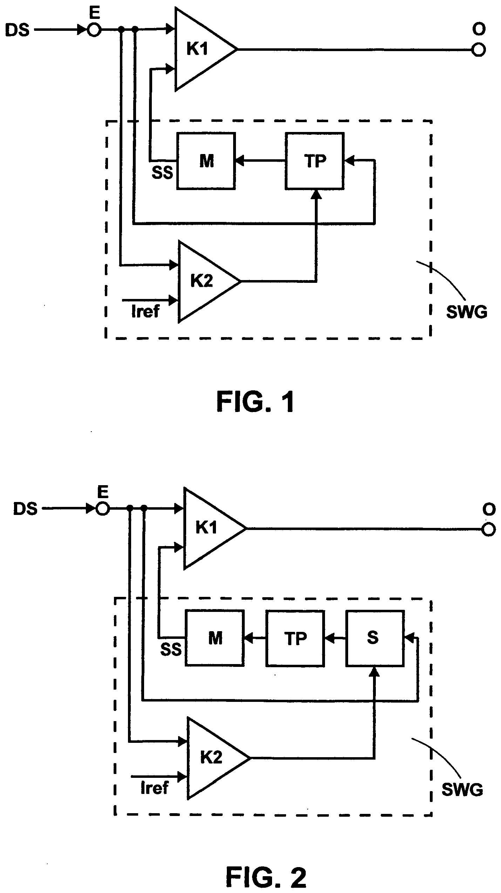

Ein erstes Ausführungsbeispiel einer Anordnung zur Ermittlung des jeweils aktuellen Pegels eines digitalen Signals ist in Figur 1 dargestellt.

Die in der Figur 1 gezeigte Anordnung weist einen Eingangsanschluß E, einen Ausgangsanschluß O, einen Komparator K1 und eine Schwellenwertbestimmungseinrichtung SWG auf, wobei die Schwellenwertbestimmungseinrichtung SWG einen zweiten Komparator K2, einen Tiefpaß TP und einen Multiplizierer M enthält.

Das digitale Signal, dessen jeweils aktueller Pegel durch die gezeigte Anordnung ermittelt werden soll, ist mit dem Bezugszeichen DS bezeichnet und wird in den Eingangsanschluß E der Anordnung eingegeben. Die Anordnung setzt dieses digitale Signal DS in ein digitales Signal um, dessen Strom- und/oder Spannungsverlauf dem Pegelverlauf des umzusetzenden Signals entspricht, und bei welchem der den niedrigen Pegel repräsentierende Strom bzw. die den niedrigen Pegel repräsentierende Spannung, und der den hohen Pegel repräsentierende Strom bzw. die den hohen Pegel repräsentierende Spannung definierte und nicht schwankende Werte aufweisen.

Das digitale Signal entspricht beispielsweise einem der in den Figuren 6A, 6B, oder 6C gezeigten digitalen Signale DS.

Das digitale Signal DS wird einem ersten Eingangsanschluß des ersten Komparators K1 zugeführt. Dem zweiten Eingangsanschluß des ersten Komparators K1 wird ein von der Schwellenwertbestimmungseinrichtung SWG erzeugter Schwellenstrom SS zugeführt.

Der erste Komparator K1 vergleicht die ihm zugeführten Ströme DS und SS und gibt ein einen hohen Pegel repräsentierendes Signal (einen einen hohen Pegel repräsentierenden Strom oder eine einen hohen Pegel repräsentierende Spannung) aus, wenn der aktuelle Wert des digitalen Signals DS größer als der Schwellenstrom SS ist, bzw. gibt ein einen niedrigen Pegel repräsentierendes Signal (einen einen niedrigen Pegel repräsentierenden Strom oder eine einen niedrigen Pegel repräsentierende Spannung) aus, wenn der aktuelle Wert des digitalen Signals DS kleiner als der Schwellenstrom SS ist (oder umgekehrt) .

Der von der Schwellenwertbestimmungseinrichtung SWG erzeugte Schwellenstrom SS ist im betrachteten Beispiel so beschaffen, daß er genau in der Mitte zwischen dem im digitalen Signal DS den niedrigen Pegel repräsentierenden Strom und dem im digitalen Signal den hohen Pegel repräsentierenden Strom liegt.

Dies wird dadurch erreicht,
- daß die Schwellenwertbestimmungseinrichtung SWG den im digitalen Signal DS den niedrigen Pegel und/oder den hohen Pegel repräsentierenden Strom ermittelt, und
- daß der durch die Schwellenwertbestimmungseinrichtung SWG zu bestimmende Schwellenstrom SS abhängig vom Ergebnis dieser Ermittlung festgelegt wird,
- wobei derjenige Teil der Schwellenwertbestimmungseinrichtung, der den den niedrigen Pegel repräsentierenden Signalzustand ermittelt, deaktiviert wird, wenn und so lange das digitale Signal einen den hohen Pegel repräsentierenden Zustand aufweist, und/oder
- wobei derjenige Teil der Schwellenwertbestimmungseinrichtung, der den den hohen Pegel repräsentierenden Signalzustand ermittelt, deaktiviert wird, wenn und so lange das digitale Signal einen den niedrigen Pegel repräsentierenden Zustand aufweist.

Derjenige Teil der Schwellenwertbestimmungseinrichtung SWG, der den im digitalen Signal DS den niedrigen Pegel und/oder den hohen Pegel repräsentierenden Strom ermittelt, ist im betrachteten Beispiel der Tiefpaß TP.

Der Tiefpaß TP unterzieht das digitale Signal DS, genauer gesagt die einen niedrigen Pegel repräsentierenden Teile desselben einer Tiefpaßfilterung.

Daß nur die niedrigen Pegel repräsentierenden Teile des digitalen Signals DS einer Tiefpaßfilterung unterzogen werden, wird dadurch erreicht, daß der Tiefpaß TP durch das Ausgangssignal des zweiten Komparators K2 aktiviert wird, wenn und so lange das digitale Signal einen einen niedrigen Pegel repräsentierenden Strom aufweist, und daß der Tiefpaß TP durch das Ausgangssignal des zweiten Komparators K2 deaktiviert wird, wenn und so lange das digitale Signal einen einen hohen Pegel repräsentierenden Strom aufweist.

Der zweite Komparator K2 vergleicht das digitale Signal DS mit einem Referenzstrom Iref, welcher beispielsweise dem Schwellenstrom Is gemäß den Figuren 6A, 6B, und 6C entspricht. Der zweite Komparator K2 gibt ein den Tiefpaß TP aktivierendes Signal aus, wenn und so lange DS kleiner als Iref ist, und gibt ein den Tiefpaß TP deaktivierendes Signal aus, wenn und so lange DS größer als Iref ist.

Das vom Tiefpaß TP ausgegebene Signal entspricht dem Gleichstromanteil der der Tiefpaßfilterung unterzogenen Teile des digitalen Signals, also dem den niedrigen Pegel repräsentierenden Strom.

Dieses Signal wird durch den Multiplizierer M multipliziert. Der Faktor, mit dem es multipliziert wird, weist im betrachteten Beispiel den Wert 1,5 auf.

Da im betrachteten Beispiel der den hohen Pegel repräsentierende Strom etwa doppelt so groß ist, wie der den niedrigen Pegel repräsentierende Strom, liegt der durch die Multiplikation erhaltene Strom genau in der Mitte zwischen dem den niedrigen Pegel repräsentierenden Strom und dem den hohen Pegel repräsentierenden Strom. Der durch die Multiplikation erhaltene Strom wird als Schwellenstrom SS verwendet und dem zweiten Eingangsanschluß des ersten Komparators K1 zugeführt.

Durch eine solche Schwellenwerterzeugung kann erreicht werden, daß kleinere Schwankungen des im digitalen Signal den niedrigen Pegel repräsentierenden Stromes und/oder des im digitalen Signal den hohen Pegel repräsentierenden Stromes nicht zu einer fehlerhaften Ermittlung des jeweils aktuellen Pegels des digitalen Signals DS führen können. Solche Schwankungen haben schlimmstenfalls zur Folge, daß der Schwellenwert nicht mehr genau in der Mitte zwischen dem den niedrigen Pegel repräsentierenden Strom und dem den hohen Pegel repräsentierenden Strom liegt, wobei diese Verschiebung des Schwellenwertes im allgemeinen sehr gering ist und nach Abklingen der die Verschiebung verursachenden Störung wieder auf null zurückgeht.

Es dürfte einleuchten, daß der Faktor, mit welchem der Multiplizierer den ihm zugeführten Strom multipliziert, nicht den im betrachteten Beispiel verwendeten Wert (1,5) aufweisen muß. Wie groß dieser Wert ist, hängt vom Einzelfall ab, genauer gesagt von dem Verhältnis, in welchem der den niedrigen Pegel repräsentierende Strom und der den hohen Pegel repräsentierenden Strom zueinander stehen, und von der gewünschten Lage des Schwellenwertes in Bezug auf den im digitalen Signal den niedrigen Pegel repräsentierenden Strom und den im digitalen Signal den hohen Pegel repräsentierenden Strom.

Es dürfte ferner einleuchten, daß man zu dem selben Ergebnis (zu dem selben Schwellenwert) gelangt, wenn die den hohen Pegel repräsentierenden Teile des digitalen Signals DS einer Tiefpaßfilterung unterzogen werden, also wenn der Tiefpaß TP durch das Ausgangssignal des zweiten Komparators K2 aktiviert wird, wenn und so lange das digitale Signal einen einen hohen Pegel repräsentierenden Strom aufweist, und der Tiefpaß durch das Ausgangssignal des zweiten Komparators K2 deaktiviert wird, wenn und so lange das digitale Signal einen einen niedrigen Pegel repräsentierenden Strom aufweist, und wenn das aus dieser Tiefpaßfilterung resultierende Signal mit einem anderen Faktor (im betrachteten Beispiel mit 0,75 multipliziert wird.

Beim Tiefpaß TP muß es sich um einen Tiefpaß handeln, der durch das Ausgangssignal des zweiten Komparators K2 angehalten werden kann. Ein Tiefpaß, bei welchem dies möglich ist, ist beispielsweise ein durch ein digitales Filter realisierter Tiefpaß.

Figur 2 zeigt ein zweites Ausführungsbeispiel einer Anordnung zur Ermittlung des jeweils aktuellen Pegels eines digitalen Signals.

Die in der Figur 2 gezeigte Anordnung entspricht weitgehend der in Figur 1 gezeigten Anordnung. Mit den gleichen Bezugszeichen bezeichnete Komponenten sind identische oder einander entsprechende Komponenten.

Die in der Figur 2 gezeigte Anordnung unterscheidet sich von der in der Figur 1 gezeigten Anordnung in der Schwellenwertbestimmungseinrichtung SWG, genauer gesagt in der Art und Weise, auf welche erreicht wird, daß nur der im digitalen Signal DS den niedrigen Pegel repräsentierende Strom einer Tiefpaßfilterung unterzogen wird. Bei der in der Figur 1 gezeigten Anordnung geschah dies dadurch, daß der Tießpaß TP durch das Ausgangssignal des zweiten Komparators K2 entsprechend gesteuert (aktiviert und deaktiviert) wird. Bei dem in der Figur 2 gezeigten Anordnung geschieht dies dadurch, daß das Ausgangssignal des zweiten Komparators K2 eine zwischen dem Eingangsanschluß E der Anordnung und dem Tiefpaß TP angeordnete Schalteinrichtung S steuert.

Die Schalteinrichtung S wird durch das Ausgangssignal des zweiten Komparators K2 in einen ersten Zustand versetzt, wenn und so lange das digitale Signal DS einen einen niedrigen Pegel repräsentierenden Strom aufweist, und wird durch das Ausgangssignal des zweiten Komparators K2 in einen zweiten Zustand versetzt, wenn und so lange das digitale Signal DS einen einen hohen Pegel repräsentierenden Strom aufweist.

Der zweite Komparator K2 vergleicht das digitale Signal DS mit einem Referenzstrom Iref, welcher beispielsweise dem Schwellenstrom Is gemäß den Figuren 6A, 6B, und 6C entspricht. Der zweite Komparator K2 gibt ein die Schalteinrichtung in den ersten Zustand versetzendes Signal aus, wenn und so lange DS kleiner als Iref ist, und gibt ein die Schalteinrichtung in den zweiten Zustand versetzendes Signal aus, wenn und so lange DS größer als Iref ist.

Wenn und so lange die Schalteinrichtung S in den ersten Zustand versetzt ist, gibt sie an den Tiefpaß TP das ihr zugeführte Signal DS oder ein diesem Signal entsprechendes Signal aus; wenn und so lange die Schalteinrichtung S in den zweiten Zustand versetzt ist, gibt sie an den Tiefpaß TP nur die Hälfte des ihr zugeführten Stromes aus.

Dadurch wird dem Tiefpaß TP zu allen Zeiten der im digitalen Signal den niedrigen Pegel repräsentierende Strom zugeführt.

Das vom Tiefpaß TP ausgegebene Signal entspricht damit wie bei der Anordnung gemäß Figur 1 dem Gleichstromanteil des im digitalen Signal den niedrigen Pegel repräsentierenden Stromes.

Man erhält bei der Anordnung gemäß Figur 2 genau den selben Schwellenstrom SS wie bei der Anordnung gemäß Figur 1, und kann folglich auch die damit verbundenen Vorteile erzielen.

Durch den Wegfall der Notwendigkeit, den einen aktivierbaren und deaktivierbaren Tiefpaß TP verwenden zu müssen, kann die Anordnung gemäß Figur 2 jedoch einfacher realisiert werden als die Anordnung gemäß Figur 1.

Es dürfte einleuchten und bedarf keiner näheren Erläuterung, daß die in der Figur 2 gezeigte Anordnung auf die selbe Art und Weise modifizierbar ist wie die in der Figur 1 gezeigte Anordnung.

Durch die in den Figuren 1 und 2 gezeigten Anordnungen läßt sich der jeweils aktuelle Pegel eines digitalen Signals DS, von welchen der den niedrigen Pegel repräsentierende Signalzustand und/oder der den hohen Pegel repräsentierende Signalzustand nicht oder nicht genau bekannt sind und/oder sich verändern können, und/oder oder von Störungen überlagert sind, zuverlässig richtig ermittelt werden.

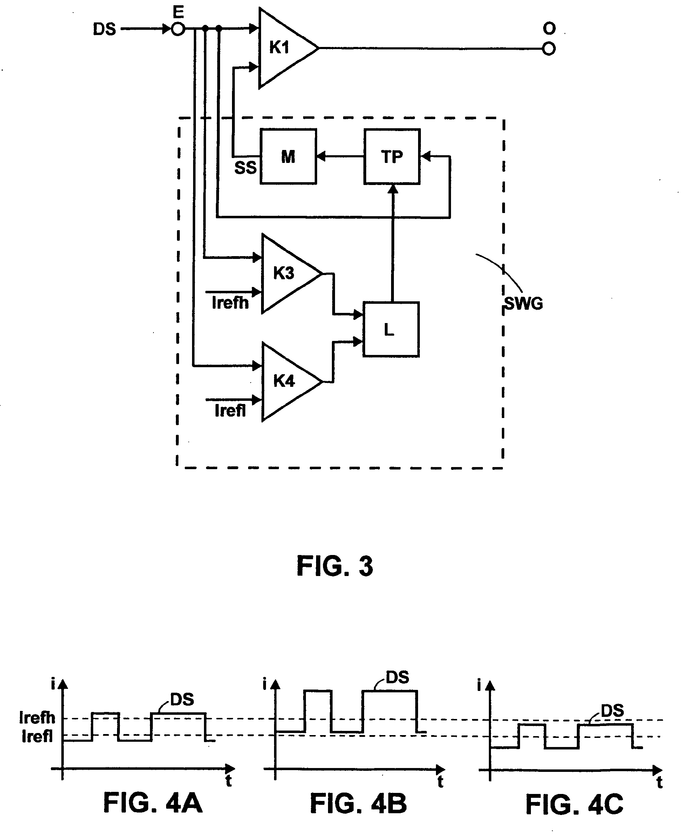

Es wird nun unter Bezugnahme auf die Figuren 3 bis 5 eine Anordnung beschrieben, durch welche die Ermittlung des jeweils aktuellen Pegels des digitalen Signals DS noch sicherer möglich ist als es mit den Anordnungen gemäß den Figuren 1 und 2 der Fall ist.

Die in der Figur 3 gezeigte Anordnung entspricht großteils der in der Figur 1 gezeigten Anordnung. Mit den gleichen Bezugszeichen bezeichnete Komponenten sind identische oder einander entsprechende Komponenten.

Die in der Figur 3 gezeigte Anordnung unterscheidet sich von der in der Figur 1 gezeigten Anordnung dadurch, daß anstelle des zweiten Komparators K2 ein dritter Komparator K3, ein vierter Komparator K4, und eine Logik L vorgesehen sind, wobei
- der dritte Komparator K3 das digitale Signal DS mit einem Referenzstrom Irefh vergleicht,
- der vierte Komparator K4 das digitale Signal DS mit einem Referenzstrom Irefl vergleicht, und
- die Logik L abhängig vom Zustand und vom Verlauf der von den Komparatoren K3 und K4 ausgegebenen Signale die Ansteuerung (die Aktivierung und die Deaktivierung) des Tiefpasses TP durchführt.

Es sei bereits an dieser Stelle darauf hingewiesen, daß die Logik L anstelle des Tiefpasses TP auch die bei der Anordnung gemäß Figur 2 verwendete Schalteinrichtung S ansteuern kann.

Die von Komparatoren K3 und K4 verwendeten Referenzströme Irefh und Irefl sind so festgelegt, daß unter allen Umständen, d.h. bei sämtlichen Verläufen, die das digitale Signal DS aufweisen kann, wenigstens der Referenzstrom Irefh oder der Referenzstrom Irefl zwischen dem im digitalen Signal DS den hohen Pegel repräsentierenden Strom und dem im digitalen Signal DS den niedrigen Pegel repräsentierenden Strom liegt, wobei es zulässig ist, daß entweder der Referenzstrom Irefh größer ist als der im digitalen Signal DS den hohen Pegel repräsentierende Strom, oder der Referenzstrom Irefl kleiner ist als der im digitalen Signal DS den niedrigen Pegel repräsentierende Strom, und wobei es nicht zulässig ist, daß der Referenzstrom Irefh kleiner ist als der im digitalen Signal DS den niedrigen Pegel repräsentierende Strom, oder der Referenzstrom Irefl größer ist als der im digitalen Signal DS den hohen Pegel repräsentierende Strom.

Eine zulässige Festlegung der Referenzströme Irefh und Irefl ist beispielhaft in den Figuren 4A, 4B, und 4C veranschaulicht.

Es ist auch möglich, der Anordnung nur einen einzigen Referenzstrom (beispielsweise den Referenzstrom Iref gemäß Figur 1 und Figur 2) zuzuführen, und die Referenzströme Irefh und Irefl aus diesem einzigen Referenzstrom zu berechnen oder auf sonstige Art und Weise zu ermitteln.

Der Komparator K3 gibt ein Signal HC an die Logik L aus, welches im betrachteten Beispiel den Wert 1 aufweist, wenn DS größer als Irefh ist, und welches den Wert 0 aufweist, wenn DS kleiner als Irefh ist.

Der Komparator K4 gibt ein Signal LC an die Logik L aus, welches im betrachteten Beispiel den Wert 1 aufweist, wenn DS größer als Irefl ist, und welches den Wert 0 aufweist, wenn DS kleiner als Irefl ist.

Die Logik L geht davon aus, daß das digitale Signal DS den niedrigen Pegel aufweist, und aktiviert den Tiefpaß TP,
- wenn LC gleich 0 ist oder wird, oder
- wenn HC von 1 auf 0 umspringt.

Die Logik L geht davon aus, daß das digitale Signal DS den hohen Pegel aufweist, und deaktiviert den Tiefpaß TP,
- wenn HC gleich 1 ist oder wird, oder
- wenn LC von 0 auf 1 umspringt.

Diese Zusammenhänge sind in dem in der Figur 5 gezeigten Zustandsdiagramm veranschaulicht.

Noch zuverlässiger funktioniert die Ermittlung des jeweils aktuellen Pegels des digitalen Signals, wenn die Komparatoren K3 und K4 eine Hysteresefunktion aufweisen, d.h., wenn der Strom, den DS überschreiten muß, damit das Ausgangssignal des jeweiligen Komparators von 0 auf 1 springt, größer ist als der Strom, den DS unterschreiten muß, damit das Ausgangssignal des jeweiligen Komparators von 1 auf 0 springt. Dann ist die Anordnung noch unempfindlicher gegen dem digitalen Signal überlagerten Störungen als es ohnehin schon der Fall ist.

Dies gilt übrigens auch für die in den Anordnungen gemäß den Figuren 1 und 2 verwendeten Komparatoren K2.

Unabhängig hiervon können die vorstehend beschriebenen Anordnungen auch dahingehend modifiziert werden, daß der Multiplizierer M nicht hinter dem Tiefpaß TP, sondern vor dem Tiefpaß angeordnet ist, oder vor der Schalteinrichtung S angeordnet ist, oder in die Schalteinrichtung S integriert ist.

Dann wird dem Tiefpaß TP ein Strom zugeführt, von dem zumindest bestimmte Teile desselben den Schwellenstrom SS repräsentieren. Der Tiefpaß TP unterzieht das ihm zugeführte Signal oder die den Schwellenstrom SS repräsentierenden Teile desselben einer Tiefpaßfilterung und gibt als Ergebnis den Schwellenstrom SS aus. Die Ansteuerung des Tiefpasses TP und/oder der Schalteinrichtung S erfolgt dabei wie es vorstehend unter Bezugnahme auf die Figuren 1 bis 5 beschrieben wurde.

Die beschriebenen Anordnungen und Verfahren ermöglichen es unabhängig von den Einzelheiten der praktischen Realisierung, daß sich der Pegel eines digitalen Signals auch dann, wenn der den niedrigen Pegel repräsentierende Signalzustand und/oder der den hohen Pegel repräsentierende Signalzustand nicht oder nicht genau bekannt sind und/oder sich verändern können, zuverlässig fehlerfrei erkennen läßt.

### Bezugszeichenliste

- DS: digitales Signal
- E: Eingangsanschluß
- Ix: Ströme
- Kx: Komparatoren
- L: Logik
- M: Multiplizierer
- O: Ausgangsanschluß
- S: Schalteinrichtung
- SS: Schwellenstrom
- SWG: Schwellenwertbestimmungseinrichtung
- TP: Tiefpaß

## Patentansprüche

1. Anordnung zur Ermittlung des jeweils aktuellen Pegels eines digitalen Signals,
- mit einer Vergleichseinrichtung (K1), welche das digitale Signal (DS) mit einem Schwellenwert (SS) vergleicht, der zwischen dem den niedrigen Pegel repräsentierenden Zustand des digitalen Signals und dem den hohen Pegel repräsentierenden Zustand des digitalen Signals liegt, und
- mit einer Schwellenwertbestimmungseinrichtung (SWG), welche den verwendeten Schwellenwert festlegt,
wobei die Schwellenwertbestimmungseinrichtung den Schwellenwert unter Berücksichtigung des zeitlichen Verlaufs des digitalen Signals festlegt, und
wobei die Schwellenwertbestimmungseinrichtung den den niedrigen Pegel und/oder den den hohen Pegel repräsentierende Zustand des digitalen Signals ermittelt, und den Schwellenwert unter Berücksichtigung des Ergebnisses dieser Ermittlung festlegt,
**dadurch gekennzeichnet,**
**daß** der Schwellenwert (SS) durch Multiplizieren des den niedrigen Pegel oder des den hohen Pegel repräsentierenden Zustandes des digitalen Signals (DS) mit einem bestimmten Faktor ermittelt wird.

2. Anordnung nach Anspruch 1,
**dadurch gekennzeichnet,**
**daß** die Ermittlung des den niedrigen und/oder des den hohen Pegel repräsentierenden Zustandes des digitalen Signals (DS) in der Ermittlung des Stromes oder der Spannung besteht, den bzw. die das digitale Signal im Mittel aufweist, wenn durch dieses ein niedriger Pegel bzw. ein hoher Pegel repräsentiert wird.

3. Anordnung nach einem der vorhergehenden Ansprüche,
**dadurch gekennzeichnet,**
**daß** der Teil der Schwellenwertbestimmungseinrichtung (SWG), der den den niedrigen Pegel und/oder den den hohen Pegel repräsentierenden Zustand des digitalen Signals (DS) ermittelt, ein Tiefpaß (TP) ist.

4. Anordnung nach einem der vorhergehenden Ansprüche,
**dadurch gekennzeichnet,**
**daß** der Teil der Schwellenwertbestimmungseinrichtung (SWG), der den den niedrigen Pegel repräsentierenden Zustand des digitalen Signals (DS) ermittelt, deaktiviert wird, wenn und so lange das digitale Signal einen den hohen Pegel repräsentierenden Zustand aufweist.

5. Anordnung nach einem der vorhergehenden Ansprüche,
**dadurch gekennzeichnet,**
**daß** der Teil der Schwellenwertbestimmungseinrichtung (SWG), der den den hohen Pegel repräsentierenden Zustand des digitalen Signals (DS) ermittelt, deaktiviert wird, wenn und so lange das digitale Signal einen den niedrigen Pegel repräsentierenden Zustand aufweist.

6. Anordnung nach Anspruch 4 oder 5,
**dadurch gekennzeichnet,**
**daß** die Aktivierung und Deaktivierung des Teils der Schwellenwertbestimmungseinrichtung (SWG), der den den niedrigen oder den den hohen Pegel repräsentierenden Zustand des digitalen Signals (DS) ermittelt, abhängig vom Ergebnis des Vergleichs des digitalen Signals mit einem Referenzstrom (Iref) oder einer Referenzspannung erfolgt.

7. Anordnung nach Anspruch 4 oder 5,
**dadurch gekennzeichnet,**
**daß** die Aktivierung und Deaktivierung des Teils der Schwellenwertbestimmungseinrichtung (SWG), der den den niedrigen oder den den hohen Pegel repräsentierenden Zustand des digitalen Signals (DS) ermittelt, abhängig von den Ergebnissen der Vergleiche des digitalen Signals mit mehreren Referenzströmen (Irefl, Irefh) oder Referenzspannungen erfolgt.

8. Anordnung nach Anspruch 6 oder 7,
**dadurch gekennzeichnet,**
**daß** die Aktivierung und Deaktivierung des Teils der Schwellenwertbestimmungseinrichtung (SWG), der den den niedrigen oder den den hohen Pegel repräsentierenden Zustand des digitalen Signals (DS) ermittelt, abhängig vom zeitlichen Verlauf der Vergleichsergebnisse erfolgt.

9. Anordnung nach einem der Ansprüche 1 bis 3,
**dadurch gekennzeichnet,**
**daß** dem Teil der Schwellenwertbestimmungseinrichtung (SWG), der den den niedrigen Pegel repräsentierenden Zustand des digitalen Signals (DS) ermittelt, eine Einrichtung (S) vorgeschaltet ist, welche dafür sorgt, daß dem Teil der Schwellenwertbestimmungseinrichtung, der den den niedrigen Pegel repräsentierenden Zustand des digitalen Signals ermittelt, ständig ein Signal zugeführt wird, welches den den niedrigen Pegel repräsentierenden Zustand aufweist.

10. Anordnung nach Anspruch 9,
**dadurch gekennzeichnet,**
**daß** die vorgeschaltete Einrichtung (S)
- dem Teil der Schwellenwertbestimmungseinrichtung (SWG), der den den niedrigen Pegel repräsentierenden Zustand des digitalen Signals (DS) ermittelt, das digitale Signal oder ein diesem Signal entsprechendes Signal zuführt, wenn und so lange das digitale Signal den den niedrigen Pegel repräsentierenden Zustand aufweist, und
- das digitale Signal (DS) in ein Signal umsetzt, welches einen einen niedrigen Pegel repräsentierenden Zustand aufweist, und dieses Signal dem Teil der Schwellenwertbestimmungseinrichtung (SWG) zuführt, der den den niedrigen Pegel repräsentierenden Zustand des digitalen Signals ermittelt, wenn und so lange das digitale Signal den den hohen Pegel repräsentierenden Zustand aufweist.

11. Anordnung nach einem der Ansprüche 1 bis 3,
**dadurch gekennzeichnet,**
**daß** dem Teil der Schwellenwertbestimmungseinrichtung (SWG), der den den hohen Pegel repräsentierenden Zustand des digitalen Signals (DS) ermittelt, eine Einrichtung (S) vorgeschaltet ist, welche dafür sorgt, daß dem Teil der Schwellenwertbestimmungseinrichtung, der den den hohen Pegel repräsentierenden Zustand des digitalen Signals ermittelt, ständig ein Signal zugeführt wird, welches den den hohen Pegel repräsentierenden Zustand aufweist.

12. Anordnung nach Anspruch 11,
**dadurch gekennzeichnet,**
**daß** die vorgeschaltete Einrichtung (S)
- dem Teil der Schwellenwertbestimmungseinrichtung (SWG), der den den hohen Pegel repräsentierenden Zustand des digitalen Signals (DS) ermittelt, das digitale Signal oder ein diesem Signal entsprechendes Signal zuführt, wenn und so lange das digitale Signal den den hohen Pegel repräsentierenden Zustand aufweist, und
- das digitale Signal (DS) in ein Signal umsetzt, welches einen einen hohen Pegel repräsentierenden Zustand aufweist, und dieses Signal dem Teil der Schwellenwertbestimmungseinrichtung (SWG) zuführt, der den den hohen Pegel repräsentierenden Zustand des digitalen Signals ermittelt, wenn und so lange das digitale Signal den den niedrigen Pegel repräsentierenden Zustand aufweist.

13. Anordnung nach einem der Ansprüche 9 bis 12,
**dadurch gekennzeichnet,**
**daß** die Steuerung der vorgeschalteten Einrichtung (S) abhängig vom Ergebnis des Vergleichs des digitalen Signals mit einem Referenzstrom (Iref) oder einer Referenzspannung erfolgt.

14. Anordnung nach einem der Ansprüche 9 bis 12,
**dadurch gekennzeichnet,**
**daß** die Steuerung der vorgeschalteten Einrichtung abhängig von den Ergebnissen der Vergleiche des digitalen Signals mit mehreren Referenzströmen (Irefl, Irefh) oder Referenzspannungen erfolgt.

15. Anordnung nach Anspruch 13 oder 14,
**dadurch gekennzeichnet,**
**daß** die Steuerung der vorgeschalteten Einrichtung (S) abhängig vom zeitlichen Verlauf der Vergleichsergebnisse erfolgt.

16. Anordnung nach Anspruch 1,
**dadurch gekennzeichnet,**
**daß** die Schwellenwertbestimmungseinrichtung eine Einrichtung (M, S) enthält, welche die den hohen Pegel repräsentierende Spannung bzw. den den hohen Pegel repräsentierenden Strom, und/oder die den niedrigen Pegel repräsentierende Spannung bzw. den den niedrigen Pegel repräsentierenden Strom in eine um einen bestimmten Faktor größere oder kleinere Spannung bzw. in einen um einen bestimmten Faktor größeren oder kleineren Strom umsetzt.

17. Anordnung nach Anspruch 16,
**dadurch gekennzeichnet,**
**daß** der Faktor so gewählt ist, daß zumindest Teile der von der Einrichtung ausgegebenen Spannung bzw. zumindest Teile des von der Einrichtung ausgegebenen Stromes bei einem nicht von Störungen überlagertem digitalen Signal (DS) den Schwellenwert (SS) repräsentieren.

18. Anordnung nach Anspruch 16 oder 17,
**dadurch gekennzeichnet,**
**daß** der Faktor abhängig vom Ergebnis des Vergleichs des digitalen Signals (DS) mit einem Referenzstrom (Iref) oder einer Referenzspannung variiert wird.

19. Anordnung nach Anspruch 16 oder 17,
**dadurch gekennzeichnet,**
**daß** der Faktor abhängig von den Ergebnissen der Vergleiche des digitalen Signals (DS) mit mehreren Referenzströmen (Irefl, Irefh) oder Referenzspannungen variiert wird.

20. Anordnung nach Anspruch 18 oder 19,
**dadurch gekennzeichnet,**
**daß** der Faktor abhängig vom zeitlichen Verlauf der Vergleichsergebnisse variiert wird.

21. Anordnung nach einem der Ansprüche 18 bis 20,
**dadurch gekennzeichnet,**
**daß** der Einrichtung (M, S) eine Mittelwertbildungseinrichtung (TP) nachgeschaltet ist, welche den Mittelwert der ihr zugeführten Spannung bzw. des ihr zugeführten Stromes bildet.

22. Anordnung nach Anspruch 21,
**dadurch gekennzeichnet,**
**daß** die Mittelwertbildungseinrichtung (TP) ein Tiefpaß ist.

23. Anordnung nach Anspruch 21 oder 22,
**dadurch gekennzeichnet,**
**daß** das Ausgangssignal der Mittelwertbildungseinrichtung (TP) als Schwellenwert (SS) verwendet wird.

24. Anordnung nach einem der Ansprüche 21 bis 23,
**dadurch gekennzeichnet,**
**daß** die Mittelwertbildungseinrichtung (TP) deaktiviert wird, wenn und so lange das digitale Signal (DS) einen den hohen Pegel repräsentierenden Zustand aufweist.

25. Anordnung nach einem der Ansprüche 21 bis 23,
**dadurch gekennzeichnet,**
**daß** die Mittelwertbildungseinrichtung (TP) deaktiviert wird, wenn und so lange das digitale Signal (DS) einen den niedrigen Pegel repräsentierenden Zustand aufweist.

26. Anordnung nach Anspruch 24 oder 25,
**dadurch gekennzeichnet,**
**daß** die Aktivierung und Deaktivierung der Mittelwertbildungseinrichtung (TP) abhängig vom Ergebnis des Vergleichs des digitalen Signals (DS) mit einem Referenzstrom (Iref) oder einer Referenzspannung erfolgt.

27. Anordnung nach Anspruch 24 oder 25,
**dadurch gekennzeichnet,**
**daß** die Aktivierung und Deaktivierung der Mittelwertbildungseinrichtung (TP) abhängig von den Ergebnissen der Vergleiche des digitalen Signals (DS) mit mehreren Referenzströmen (Irefl, Irefh) oder Referenzspannungen erfolgt.

28. Anordnung nach Anspruch 26 oder 27,
**dadurch gekennzeichnet,**
**daß** die Aktivierung und Deaktivierung der Mittelwertbildungseinrichtung (TP) abhängig vom zeitlichen Verlauf der Vergleichsergebnisse erfolgt.

29. Verfahren zur Ermittlung des jeweils aktuellen Pegels eines digitalen Signals,
- wobei das digitale Signal (DS) mit einem Schwellenwert (SS) verglichen wird, der zwischen dem den niedrigen Pegel repräsentierenden Zustand des digitalen Signals und dem den hohen Pegel repräsentierenden Zustand des digitalen Signals liegt,
- wobei ein an die herrschenden Bedingungen angepaßter Schwellenwert verwendet wird,
- wobei der Schwellenwert unter Berücksichtigung des zeitlichen Verlaufs des digitalen Signals festgelegt wird, und
- wobei der den niedrigen Pegel und/oder der den hohen Pegel repräsentierende Zustand des digitalen Signals ermittelt wird, und der Schwellenwert unter Berücksichtigung des Ergebnisses dieser Ermittlung festgelegt wird,
**dadurch gekennzeichnet,**
**daß** der Schwellenwert (SS) durch Multiplizieren des den niedrigen Pegel oder des den hohen Pegel repräsentierenden Zustandes des digitalen Signals (DS) mit einem bestimmten Faktor ermittelt wird.

30. Verfahren nach Anspruch 29,
**dadurch gekennzeichnet,**
**daß** die Ermittlung des den niedrigen und/oder des den hohen Pegel repräsentierenden Zustandes des digitalen Signals (DS) in der Ermittlung des Stromes oder der Spannung besteht, den bzw. die das digitale Signal im Mittel aufweist, wenn durch dieses ein niedriger Pegel bzw. ein hoher Pegel repräsentiert wird.

31. Verfahren nach einem der Ansprüche 29 oder 30,
**dadurch gekennzeichnet,**
**daß** die Ermittlung des den niedrigen Pegel und/oder des den hohen Pegel repräsentierenden Zustandes des digitalen Signals (DS) durch einen Tiefpaß (TP) erfolgt.

32. Verfahren nach einem der Ansprüche 29 bis 31,
**dadurch gekennzeichnet,**
**daß** der Teil der Anordnung (SWG), der den den niedrigen Pegel repräsentierenden Zustand des digitalen Signals (DS) ermittelt, deaktiviert wird, wenn und so lange das digitale Signal einen den hohen Pegel repräsentierenden Zustand aufweist.

33. Verfahren nach einem der Ansprüche 29 bis 32,
**dadurch gekennzeichnet,**
**daß** der Teil der Anordnung (SWG), der den den hohen Pegel repräsentierenden Zustand des digitalen Signals (DS) ermittelt, deaktiviert wird, wenn und so lange das digitale Signal einen den niedrigen Pegel repräsentierenden Zustand aufweist.

34. Verfahren nach Anspruch 32 oder 33,
**dadurch gekennzeichnet,**
**daß** die Aktivierung und Deaktivierung des Teils der Anordnung (SWG), der den den niedrigen oder den den hohen Pegel repräsentierenden Zustand des digitalen Signals (DS) ermittelt, abhängig vom Ergebnis des Vergleichs des digitalen Signals (DS) mit einem Referenzstrom (Iref) oder einer Referenzspannung erfolgt.

35. Verfahren nach Anspruch 32 oder 33,
**dadurch gekennzeichnet,**
**daß** die Aktivierung und Deaktivierung des Teils der Anordnung (SWG), der den den niedrigen oder den den hohen Pegel repräsentierenden Zustand des digitalen Signals (DS) ermittelt, abhängig von den Ergebnissen der Vergleiche des digitalen Signals mit mehreren Referenzströmen (Irefl, Irefh) oder Referenzspannungen erfolgt.

36. Verfahren nach Anspruch 34 oder 35,
**dadurch gekennzeichnet,**
**daß** die Aktivierung und Deaktivierung des Teils der Anordnung (SWG), der den den niedrigen oder den den hohen Pegel repräsentierenden Zustand des digitalen Signals (DS) ermittelt, abhängig vom zeitlichen Verlauf der Vergleichsergebnisse erfolgt.

37. Verfahren nach einem der Ansprüche 29 bis 31,
**dadurch gekennzeichnet,**
**daß** dem Teil der Anordnung (SWG), der den den niedrigen Pegel repräsentierenden Zustand des digitalen Signals (DS) ermittelt, eine Einrichtung (S) vorgeschaltet ist, welche dafür sorgt, daß dem Teil der Anordnung, der den den niedrigen Pegel repräsentierenden Zustand des digitalen Signals ermittelt, ständig ein Signal zugeführt wird, welches den den niedrigen Pegel repräsentierenden Zustand aufweist.

38. Verfahren nach Anspruch 37,
**dadurch gekennzeichnet,**
**daß** die vorgeschaltete Einrichtung (S) so angesteuert wird, daß sie
- dem Teil der Anordnung (SWG), der den den niedrigen Pegel repräsentierenden Zustand des digitalen Signals (DS) ermittelt, das digitale Signal oder ein diesem Signal entsprechendes Signal zuführt, wenn und so lange das digitale Signal den den niedrigen Pegel repräsentierenden Zustand aufweist, und
- das digitale Signal (DS) in ein Signal umsetzt, welches einen einen niedrigen Pegel repräsentierenden Zustand aufweist, und dieses Signal dem Teil der Anordnung (SWG) zuführt, der den den niedrigen Pegel repräsentierenden Zustand des digitalen Signals ermittelt, wenn und so lange das digitale Signal den den hohen Pegel repräsentierenden Zustand aufweist.

39. Verfahren nach einem der Ansprüche 29 bis 31,
**dadurch gekennzeichnet,**
**daß** dem Teil der Anordnung (SWG), der den den hohen Pegel repräsentierenden Zustand des digitalen Signals (DS) ermittelt, eine Einrichtung (S) vorgeschaltet ist, welche dafür sorgt, daß dem Teil der Anordnung, der den den hohen Pegel repräsentierenden Zustand des digitalen Signals ermittelt, ständig ein Signal zugeführt wird, welches den den hohen Pegel repräsentierenden Zustand aufweist.

40. Verfahren nach Anspruch 39,
**dadurch gekennzeichnet,**
**daß** die vorgeschaltete Einrichtung (S) so angesteuert wird, daß sie
- dem Teil der Anordnung (SWG), der den den hohen Pegel repräsentierenden Zustand des digitalen Signals (DS) ermittelt, das digitale Signal (DS) oder ein diesem Signal entsprechendes Signal zuführt, wenn und so lange das digitale Signal den den hohen Pegel repräsentierenden Zustand aufweist, und
- das digitale Signal (DS) in ein Signal umsetzt, welches einen einen hohen Pegel repräsentierenden Zustand aufweist, und dieses Signal dem Teil der Anordnung (SWG) zuführt, der den den hohen Pegel repräsentierenden Zustand des digitalen Signals ermittelt, wenn und so lange das digitale Signal den den niedrigen Pegel repräsentierenden Zustand aufweist.

41. Verfahren nach einem der Ansprüche 37 bis 40,
**dadurch gekennzeichnet,**
**daß** die Steuerung der vorgeschalteten Einrichtung (S) abhängig vom Ergebnis des Vergleichs des digitalen Signals (DS) mit einem Referenzstrom (Iref) oder einer Referenzspannung erfolgt.

42. Verfahren nach einem der Ansprüche 37 bis 40,
**dadurch gekennzeichnet,**
**daß** die Steuerung der vorgeschalteten Einrichtung (S) abhängig von den Ergebnissen der Vergleiche des digitalen Signals (DS) mit mehreren Referenzströmen (Irefl, Irefh) oder Referenzspannungen erfolgt.

43. Verfahren nach Anspruch 41 oder 42,
**dadurch gekennzeichnet,**
**daß** die Steuerung der vorgeschalteten Einrichtung (S) abhängig vom zeitlichen Verlauf der Vergleichsergebnisse erfolgt.

44. Verfahren nach Anspruch 29,
**dadurch gekennzeichnet,**
**daß** die Schwellenwertbestimmungseinrichtung eine Einrichtung (M, S) enthält, durch welche die den hohen Pegel repräsentierende Spannung bzw. den den hohen Pegel repräsentierenden Strom, und/oder die den niedrigen Pegel repräsentierende Spannung bzw. den den niedrigen Pegel repräsentierenden Strom in eine um einen bestimmten Faktor größere oder kleinere Spannung bzw. in einen um einen bestimmten Faktor größeren oder kleineren Strom umgesetzt wird.

45. Verfahren nach Anspruch 44,
**dadurch gekennzeichnet,**
**daß** der Faktor so gewählt wird, daß zumindest Teile der von der Einrichtung ausgegebenen Spannung bzw. zumindest Teile des von der Einrichtung ausgegebenen Stromes bei einem nicht von Störungen überlagertem digitalen Signal (DS) den Schwellenwert (SS) repräsentieren.

46. Verfahren nach Anspruch 44 oder 45,
**dadurch gekennzeichnet,**
**daß** der Faktor abhängig vom Ergebnis des Vergleichs des digitalen Signals (DS) mit einem Referenzstrom (Iref) oder einer Referenzspannung variiert wird.

47. Verfahren nach Anspruch 44 oder 45,
**dadurch gekennzeichnet,**
**daß** der Faktor abhängig von den Ergebnissen der Vergleiche des digitalen Signals (DS) mit mehreren Referenzströmen (Irefl, Irefh) oder Referenzspannungen variiert wird.

48. Verfahren nach Anspruch 46 oder 47,
**dadurch gekennzeichnet,**
**daß** der Faktor abhängig vom zeitlichen Verlauf der Vergleichsergebnisse variiert wird.

49. Verfahren nach einem der Ansprüche 44 bis 48,
**dadurch gekennzeichnet,**
**daß** der Einrichtung (M, S) eine Mittelwertbildungseinrichtung (TP) nachgeschaltet ist, welche den Mittelwert der ihr zugeführten Spannung bzw. des ihr zugeführten Stromes bildet.

50. Verfahren nach Anspruch 49,
**dadurch gekennzeichnet,**
**daß** die Mittelwertbildungseinrichtung (TP) ein Tiefpaß ist.

51. Verfahren nach Anspruch 49 oder 50,
**dadurch gekennzeichnet,**
**daß** das Ausgangssignal der Mittelwertbildungseinrichtung (TP) als Schwellenwert (SS) verwendet wird.

52. Verfahren nach einem der Ansprüche 49 bis 51,
**dadurch gekennzeichnet,**
**daß** die Mittelwertbildungseinrichtung (TP) deaktiviert wird, wenn und so lange das digitale Signal (DS) einen den hohen Pegel repräsentierenden Zustand aufweist.

53. Verfahren nach einem der Ansprüche 49 bis 51,
**dadurch gekennzeichnet,**
**daß** die Mittelwertbildungseinrichtung (TP) deaktiviert wird, wenn und so lange das digitale Signal (DS) einen den niedrigen Pegel repräsentierenden Zustand aufweist.

54. Verfahren nach Anspruch 52 oder 53,
**dadurch gekennzeichnet,**
**daß** die Aktivierung und Deaktivierung der Mittelwertbildungseinrichtung (TP) abhängig vom Ergebnis des Vergleichs des digitalen Signals (DS) mit einem Referenzstrom (Iref) oder einer Referenzspannung erfolgt.

55. Verfahren nach Anspruch 52 oder 53,
**dadurch gekennzeichnet,**
**daß** die Aktivierung und Deaktivierung der Mittelwertbildungseinrichtung (TP) abhängig von den Ergebnissen der Vergleiche des digitalen Signals (DS) mit mehreren Referenzströmen (Irefl, Irefh) oder Referenzspannungen erfolgt.

56. Verfahren nach Anspruch 54 oder 55,
**dadurch gekennzeichnet,**
**daß** die Aktivierung und Deaktivierung der Mittelwertbildungseinrichtung (TP) abhängig vom zeitlichen Verlauf der Vergleichsergebnisse erfolgt.

## Claims

1. Arrangement for determining the respectively present level of a digital signal,
- having a comparison device (K1) which compares the digital signal (DS) with a threshold value (SS) which is located between the state which represents the low level of the digital signal and the state which represents the high level of the digital signal, and
- having a threshold value determining device (SWG), which defines the threshold value which is used,
wherein the threshold value determining device defines the threshold value taking account of the waveform of the digital signal, and
wherein the threshold value determining device determines the state which represents the low level of the digital signal and/or the state which represents the high level of the digital signal, and defines the threshold value taking account of the result of this determination process, **characterized in that**
the threshold value (SS) is determined by multiplying that state which represents the low level of the digital signal (DS) or that state which represents the high level of the digital signal (DS) by a specific factor.

2. Arrangement according to Claim 1,
**characterized in that**
the determination of the state which represents the low level of the digital signal (DS) and/or of the state which represents the high level of the digital signal (DS) comprises the determination of the current or of the voltage which the digital signal has on average when it is represented by this low level or high level.

3. Arrangement according to one of the preceding claims,
**characterized in that**
the part of the threshold value determining device (SWG) which determines the state which represents the low level of the digital signal (DS) and/or the state which represents the high level of the digital signal (DS) is a low-pass filter (TP)

4. Arrangement according to one of the preceding claims,
**characterized in that**
the part of the threshold value determining device (SWG) which determines the state which represents the low level of the digital signal (DS) is deactivated when and for as long as the digital signal is in the state which represents the high level.

5. Arrangement according to one of the preceding claims,
**characterized in that**
the part of the threshold value determining device (SWG) which determines the state which represents the high level of the digital signal (DS) is deactivated when and for as long as the digital signal is in the state which represents the low level.

6. Arrangement according to Claim 4 or 5,
**characterized in that**
the activation and deactivation of the part of the threshold value determining device (SWG) which determines the state which represents the low level of the digital signal (DS) or the state which represents the high level of the digital signal (DS) is carried out as a function of the result of the comparison of the digital signal with a reference current (Iref) or a reference voltage.

7. Arrangement according to Claim 4 or 5,
**characterized in that**
the activation and deactivation of the part of the threshold value determining device (SWG) which determines the state which represents the low level of the digital signal (DS) or the state which represents the high level of the digital signal (DS) is carried out as a function of the results of the comparisons of the digital signal with a number of reference currents (Irefl, Irefh) or reference voltages.

8. Arrangement according to Claim 6 or 7,
**characterized in that**
the activation and deactivation of the part of the threshold value determining device (SWG) which determines the state which represents the low level of the digital signal (DS) or the state which represents the high level of the digital signal (DS) is carried out as a function of the waveform of the comparison results.

9. Arrangement according to one of Claims 1 to 3,
**characterized in that**
that part of the threshold value determining device (SWG) which determines the state which represents the low level of the digital signal (DS) is preceded by a device (S) which ensures that that part of the threshold value determining device which determines the state which represents the low level of the digital signal is continuously supplied with a signal which is in the state which represents the low level.

10. Arrangement according to Claim 9,
**characterized in that**
the upstream device (S)
- supplies the digital signal or a signal which corresponds to this signal to that part of the threshold value determining device (SWG) which determines the state which represents the low level of the digital signal (DS), when and for as long as the digital signal is in the state which represents the low level, and
- converts the digital signal (DS) to a signal which is in a state which represents a low level, and supplies this signal to that part of the threshold value determining device (SWG) which determines the state which represents the low level of the digital signal, when and for as long as the digital signal is in the state which represents the high level.

11. Arrangement according to one of Claims 1 to 3,
**characterized in that**
that part of the threshold value determining device (SWG) which determines the state which represents the high level of the digital signal (DS) is preceded by a device (S) which ensures that that part of the threshold value determining device which determines the state which represents the high level of the digital signal is continuously supplied with a signal which is in the state which represents the high level.

12. Arrangement according to Claim 11,
**characterized in that**
the upstream device (S)
- supplies the digital signal or a signal which corresponds to this signal to that part of the threshold value determining device (SWG) which determines the state which represents the high level of the digital signal (DS), when and for as long as the digital signal is in the state which represents the high level, and
- converts the digital signal (DS) to a signal which is in a state which represents a high level, and supplies this signal to that part of the threshold value determining device (SWG) which determines the state which represents the high level of the digital signal, when and for as long as the digital signal is in the state which represents the low level.

13. Arrangement according to one of Claims 9 to 12, **characterized in that**
the upstream device (S) is controlled as a function of the result of the comparison of the digital signal with a reference current (Iref) or a reference voltage.

14. Arrangement as according to one of the Claims 9 to 12,
**characterized in that**
the upstream device (S) is controlled as a function of the results of the comparisons of the digital signal with a number of reference currents (Irefl, Irefh) or reference voltages.

15. Arrangement as according to Claim 13 or 14, **characterized in that**
the upstream device (S) is controlled as a function of the waveform of the comparison results.

16. Arrangement according to Claim 1,
**characterized in that**
the threshold value determining device contains a device (M, S) which converts the voltage which represents the high level or the current which represents the high level, and/or the voltage which represents the low level or the current which represents the low level to a voltage which is greater or less by a specific factor, or to a current which is greater or less by a specific factor.

17. Arrangement according to Claim 16,
**characterized in that**
the factor is chosen such that at least parts of the voltage which is emitted from the device or at least parts of the current which is emitted from the device represent the threshold value (SS) for a digital signal (DS) on which no disturbances are superimposed.

18. Arrangement according to Claim 16 or 17,
**characterized in that**
the factor is varied as a function of the result of the comparison of the digital signal (DS) with a reference current (Iref) or a reference voltage.

19. Arrangement according to Claim 16 or 17,
**characterized in that**
the factor is varied as a function of the results of the comparisons of the digital signal (DS) with a number of reference currents (Irefl, Irefh) or reference voltages.

20. Arrangement as according to Claim 18 or 19,
**characterized in that**
the factor is varied as a function of the waveform of the comparison results.

21. Arrangement according to one of Claims 18 to 20,
**characterized in that**
the device (M, S) is followed by an averaging device (TP) which forms the mean value of the voltage supplied to it or of the current supplied to it.

22. Arrangement according to Claim 21,
**characterized in that**
the averaging device (TP) is a low-pass filter.

23. Arrangement according to Claim 21 or 22,
**characterized in that**
the output signal from the averaging device (TP) is used as the threshold value (SS).

24. Arrangement according to one of Claims 21 to 23, **characterized in that**
the averaging device (TP) is deactivated when and for as long as the digital signal (DS) is in a state which represents the high level.

25. Arrangement according to one of Claims 21 to 23,
**characterized in that**
the averaging device (TP) is deactivated when and for as long as the digital signal (DS) is in a state which represents the low level.

26. Arrangement according Claim 24 or 25,
**characterized in that**
the activation and deactivation of the averaging device (TP) are carried out as a function of the result of the comparison of the digital signal (DS) with a reference current (Iref) or a reference voltage.

27. Arrangement according to Claim 24 or 25,
**characterized in that**
the activation and deactivation of the averaging device (TP) are carried out as a function of the results of the comparisons of the digital signal (DS) with a number of reference currents (Irefl, Irefh) or reference voltages.

28. Arrangement according to Claim 26 or 27,
**characterized in that** the activation and deactivation of the averaging device (TP) are carried out as a function of the waveform of the comparison results.

29. Method for determining the respectively present level of a digital signal,
- in which the digital signal (DS) is compared with a threshold value (SS) which is located between the state which represents the low level of the digital signal and the state which represents the high level of the digital signal, and
- in which a threshold value which is matched to the prevailing conditions is used,
- in which the threshold value is defined taking account of the waveform of the digital signal, and
- in which the state which represents the low level of the digital signal and/or the state which represents the high level of the digital signal is determined, and the threshold value is defined taking into account the result of this determination process,
**characterized in that**
the threshold value (SS) is determined by multiplying that state which represents the low level of the digital signal (DS) or that state which represents the high level of the digital signal (DS) by a specific factor.

30. Method according to Claim 29,
**characterized in that**
the determination of the state which represents the low level of the digital signal (DS) and/or of the state which represents the high level of the digital signal (DS) comprises the determination of the current or of the voltage which the digital signal has on average when it is represented by this low level or high level.

31. Method according to one of Claims 29 or 30,
**characterized in that**
the determination of the state which represents the low level of the digital signal (DS) and/or of the state which represents the high level of the digital signal (DS) is carried out by means of a low-pass filter (TP).

32. Method according to one of Claims 29 to 31,
**characterized in that**
that part of the arrangement (SWG) which determines the state which represents the low level of the digital signal (DS) is deactivated when and for as long as the digital signal is in the state which represents the high level.

33. Method according to one of Claims 29 to 32, **characterized in that**
that part of the arrangement (SWG) which determines the state which represents the high level of the digital signal (DS) is deactivated when and for as long as the digital signal is in the state which represents the low level.

34. Method according to Claim 32 or 33,
**characterized in that**
the activation and deactivation of that part of the arrangement (SWG) which determines the state which represents the low level of the digital signal (DS) or the state which represents the high level of the digital signal (DS) are carried out as a function of the result of the comparison of the digital signal (DS) with a reference current (Iref) or a reference voltage.

35. Method according to Claim 32 or 33,
**characterized in that**
the activation and deactivation of that part of the arrangement (SWG) which determines the state which represents the low level of the digital signal (DS) or the state which represents the high level of the digital signal (DS) are carried out as a function of the results of the comparisons of the digital signal with a number of reference currents (Irefl, Irefh) or reference voltages.

36. Method according to Claim 34 or 35,
**characterized in that**
the activation and deactivation of that part of the arrangement (SWG) which determines the state which represents the low level of the digital signal (DS) or the state which represents the high level of the digital signal (DS) are carried out as a function of the waveform of the comparison results.

37. Method according to one of Claims 29 to 31, **characterized in that**
that part of the arrangement (SWG) which determines the state which represents the low level of the digital signal (DS) is preceded by a device (S) which ensures that that part of the arrangement which determines the state which represents the low level of the digital signal is continuously supplied with a signal which is in the state which represents the low level.

38. Method according to Claim 37,
**characterized in that**
the upstream device (S) is driven such that it
- supplies the digital signal or a signal which corresponds to this signal to that part of the arrangement (SWG) which determines the state which represents the low level of the digital signal (DS), when and for as long as the digital signal is in the state which represents the low level, and
- converts the digital signal (DS) to a signal which is in a state which represents a low level, and supplies this signal to that part of the arrangement (SWG) which determines the state which represents the low level of the digital signal, when and for as long as the digital signal is in the state which represents the high level.

39. Method according to one of Claims 29 to 31,
**characterized in that**
that part of the arrangement (SWG) which determines the state which represents the high level of the digital signal (DS) is preceded by a device (S) which ensures that that part of the arrangement which determines the state which represents the high level of the digital signal is continuously supplied with a signal which is in the state which represents the high level.

40. Method according to Claim 39,
**characterized in that**
the upstream device (S) is driven such that it
- supplies the digital signal (DS) or a signal which corresponds to this signal to that part of the arrangement (SWG) which determines the state which represents the high level of the digital signal (DS), when and for as long as the digital signal is in the state which represents the high level, and
- converts the digital signal (DS) to a signal which is in a state which represents a high level, and supplies this signal to that part of the arrangement (SWG) which determines the state which represents the high level of the digital signal, when and for as long as the digital signal is in the state which represents the low level.

41. Method according to one of Claims 37 to 40,
**characterized in that**
the upstream device (S) is controlled as a function of the result of the comparison of the digital signal (DS) with a reference current (Iref) or a reference voltage.

42. Method according to one of the Claims 37 to 40,
**characterized in that**
the upstream device (S) is controlled as a function of the results of the comparisons of the digital signal (DS) with a number of reference currents (Irefl, Irefh) or reference voltages.

43. Method according to Claim 41 or 42,
**characterized in that**
the upstream device (S) is controlled as a function of the waveform of the comparison results.

44. Method according to Claim 29,
**characterized in that**
the threshold value determining device contains a device (M, S) which converts the voltage which represents the high level or the current which represents the high level, and/or the voltage which represents the low level or the current which represents the low level to a voltage which is greater or less by a specific factor, or to a current which is greater or less by a specific factor.

45. Method according to Claim 44,
**characterized in that**
the factor is chosen such that at least parts of the voltage which is emitted from the device or at least parts of the current which is emitted from the device represent the threshold value (SS) for a digital signal (DS) on which no disturbances are superimposed.

46. Method according to Claim 44 or 45,
**characterized in that**
the factor is varied as a function of the result of the comparison of the digital signal (DS) with a reference current (Iref) or a reference voltage.

47. Method according to Claim 44 or 45,
**characterized in that**
the factor is varied as a function of the results of the comparisons of the digital signal (DS) with a number of reference currents (Irefl, Irefh) or reference voltages.

48. Method according to Claim 46 or 47,
**characterized in that**
the factor is varied as a function of the waveform of the comparison results.

49. Method according to one of Claims 44 to 48,
**characterized in that**
the device (M, S) is followed by an averaging device (TP) which forms the mean value of the voltage supplied to it or of the current supplied to it.

50. Method according to Claim 49,
**characterized in that**
the averaging device (TP) is a low-pass filter.

51. Method according to Claim 49 or 50,
**characterized in that**
the output signal from the averaging device (TP) is used as the threshold value (SS).

52. Method according to one of Claims 49 to 51,
**characterized in that**
the averaging device (TP) is deactivated when and for as long as the digital signal (DS) is in a state which represents the high level.

53. Method according to one of Claims 49 to 51, **characterized in that**
the averaging device (TP) is deactivated when and for as long as the digital signal (DS) is in a state which represents the low level.

54. Method according to Claim 52 or 53,
**characterized in that**
the activation and deactivation of the averaging device (TP) are carried out as a function of the result of the comparison of the digital signal (DS) with a reference current (Iref) or a reference voltage.

55. Method according to Claim 52 or 53,
**characterized in that**
the activation and deactivation of the averaging device (TP) are carried out as a function of the results of the comparisons of the digital signal (DS) with a number of reference currents (Irefl, Irefh) or reference voltages.

56. Method according to Claim 54 or 55,
**characterized in that** the activation and deactivation of the averaging device (TP) are carried out as a function of the waveform of the comparison results.

## Revendications

1. Arrangement pour déterminer le niveau respectivement actuel d'un signal numérique,
- comprenant un dispositif de comparaison (K1) qui compare le signal numérique (DS) avec une valeur de seuil (SS), laquelle se trouve entre l'état du signal numérique qui représente le niveau bas et l'état du signal numérique qui représente le niveau haut, et
- comprenant un dispositif de détermination de valeur de seuil (SWG) qui définit la valeur de seuil employée,
le dispositif de détermination de valeur de seuil définissant la valeur de seuil en tenant compte de la progression dans le temps du signal numérique, et
le dispositif de détermination de valeur de seuil déterminant l'état du signal numérique qui représente le niveau bas et/ou le niveau haut et définissant la valeur de seuil en tenant compte du résultat de cette détermination,
**caractérisé en ce que**
la valeur de seuil (SS) est déterminée en multipliant l'état du signal numérique (DS) qui représente le niveau bas et/ou le niveau haut par un facteur donné.

2. Arrangement selon la revendication 1, **caractérisé en ce que** la détermination de l'état du signal numérique (DS) qui représente le niveau bas et/ou le niveau haut se compose de la détermination du courant ou de la tension que présente le signal numérique en moyenne lorsqu'un niveau plus bas ou un niveau plus haut est représenté par celle-ci.

3. Arrangement selon l'une des revendications précédentes, **caractérisé en ce que** la partie du dispositif de détermination de valeur de seuil (SWG) qui détermine l'état du signal numérique (DS) qui représente le niveau bas et/ou le niveau haut est un filtre passe-bas (TP).

4. Arrangement selon l'une des revendications précédentes, **caractérisé en ce que** la partie du dispositif de détermination de valeur de seuil (SWG) qui détermine l'état du signal numérique (DS) qui représente le niveau bas est désactivée lorsque et tant que le signal numérique présente un état qui représente le niveau haut.

5. Arrangement selon l'une des revendications précédentes, **caractérisé en ce que** la partie du dispositif de détermination de valeur de seuil (SWG) qui détermine l'état du signal numérique (DS) qui représente le niveau haut est désactivée lorsque et tant que le signal numérique présente un état qui représente le niveau bas.

6. Arrangement selon la revendication 4 ou 5, **caractérisé en ce que** l'activation et la désactivation de la partie du dispositif de détermination de valeur de seuil (SWG) qui détermine l'état du signal numérique (DS) qui représente le niveau bas ou le niveau haut s'effectuent en fonction du résultat de la comparaison du signal numérique avec un courant de référence (Iref) ou une tension de référence.

7. Arrangement selon la revendication 4 ou 5, **caractérisé en ce que** l'activation et la désactivation de la partie du dispositif de détermination de valeur de seuil (SWG) qui détermine l'état du signal numérique (DS) qui représente le niveau bas ou le niveau haut s'effectuent en fonction des résultats des comparaisons du signal numérique avec plusieurs courants de référence (Irefl, Irefh) ou tensions de référence.

8. Arrangement selon la revendication 4 ou 5, **caractérisé en ce que** l'activation et la désactivation de la partie du dispositif de détermination de valeur de seuil (SWG) qui détermine l'état du signal numérique (DS) qui représente le niveau bas ou le niveau haut s'effectuent en fonction de la progression dans le temps des résultats des comparaisons.

9. Arrangement selon l'une des revendications 1 à 3, **caractérisé en ce qu'**en amont de la partie du dispositif de détermination de valeur de seuil (SWG) qui détermine l'état du signal numérique (DS) qui représente le niveau bas est branché un dispositif (S) qui veille à ce qu'à la partie du dispositif de détermination de valeur de seuil (SWG) qui détermine l'état du signal numérique (DS) qui représente le niveau bas soit constamment acheminé un signal qui présente l'état représentant le niveau bas.

10. Arrangement selon la revendication 9, **caractérisé en ce que** le dispositif (S) branché en amont
- achemine le signal numérique ou un signal correspondant à ce signal à la partie du dispositif de détermination de valeur de seuil (SWG) qui détermine l'état du signal numérique (DS) qui représente le niveau bas lorsque et tant que le signal numérique présente l'état qui représente le niveau bas, et
- convertit le signal numérique (DS) en un signal qui présente un état qui représente un niveau bas et achemine ce signal à la partie du dispositif de détermination de valeur de seuil (SWG) qui détermine l'état du signal numérique (DS) qui représente le niveau bas lorsque et tant que le signal numérique présente l'état qui représente le niveau haut.

11. Arrangement selon l'une des revendications 1 à 3, **caractérisé en ce qu'**en amont de la partie du dispositif de détermination de valeur de seuil (SWG) qui détermine l'état du signal numérique (DS) qui représente le niveau haut est branché un dispositif (S) qui veille à ce qu'à la partie du dispositif de détermination de valeur de seuil (SWG) qui détermine l'état du signal numérique (DS) qui représente le niveau haut soit constamment acheminé un signal qui présente l'état représentant le niveau haut.

12. Arrangement selon la revendication 11, **caractérisé en ce que** le dispositif (S) branché en amont
- achemine le signal numérique ou un signal correspondant à ce signal à la partie du dispositif de détermination de valeur de seuil (SWG) qui détermine l'état du signal numérique (DS) qui représente le niveau haut lorsque et tant que le signal numérique présente l'état qui représente le niveau haut, et
- convertit le signal numérique (DS) en un signal qui présente un état qui représente un niveau haut et achemine ce signal à la partie du dispositif de détermination de valeur de seuil (SWG) qui détermine l'état du signal numérique (DS) qui représente le niveau haut lorsque et tant que le signal numérique présente l'état qui représente le niveau bas.

13. Arrangement selon l'une des revendications 9 à 12, **caractérisé en ce que** la commande du dispositif (S) branché en amont s'effectue en fonction du résultat de la comparaison du signal numérique avec un courant de référence (Iref) ou une tension de référence.

14. Arrangement selon l'une des revendications 9 à 12, **caractérisé en ce que** la commande du dispositif (S) branché en amont s'effectue en fonction des résultats des comparaisons du signal numérique avec plusieurs courants de référence (Irefl, Irefh) ou tensions de référence.

15. Arrangement selon la revendication 13 ou 14, **caractérisé en ce que** la commande du dispositif (S) branché en amont s'effectue en fonction de la progression dans le temps des résultats des comparaisons.

16. Arrangement selon la revendication 1, **caractérisé en ce que** le dispositif de détermination de valeur de seuil contient un dispositif (M, S) qui convertit la tension qui représente le niveau haut ou le courant qui représente le niveau haut et/ou la tension qui représente le niveau bas ou le courant qui représente le niveau bas en une tension supérieure ou inférieure d'un facteur donné ou en courant supérieur ou inférieur d'un facteur donné.

17. Arrangement selon la revendication 16, **caractérisé en ce que** le facteur est choisi de telle sorte qu'au moins des parties de la tension délivrée par le dispositif ou au moins des parties du courant délivré par le dispositif représentent la valeur de seuil (SS) dans le cas d'un signal numérique (DS) auquel ne sont pas superposées des perturbations.

18. Arrangement selon la revendication 16 ou 17, **caractérisé en ce que** le facteur est soumis à une variation en fonction du résultat de la comparaison du signal numérique (DS) avec un courant de référence (Iref) ou une tension de référence.

19. Arrangement selon la revendication 16 ou 17, **caractérisé en ce que** le facteur est soumis à une variation en fonction du résultat des comparaisons du signal numérique (DS) avec plusieurs courants de référence (Irefl, Irefh) ou tensions de référence.

20. Arrangement selon la revendication 18 ou 19, **caractérisé en ce que** le facteur est soumis à une variation en fonction de la progression dans le temps des résultats des comparaisons.

21. Arrangement selon l'une des revendications 18 à 20, **caractérisé en ce qu'**en aval du dispositif (M, S) est branché un dispositif de calcul de valeur moyenne (TP) qui calcule la valeur moyenne de la tension qui lui est acheminée ou du courant qui lui est acheminé.

22. Arrangement selon la revendication 21, **caractérisé en ce que** le dispositif de calcul de valeur moyenne (TP) est un filtre passe-bas.

23. Arrangement selon la revendication 21 ou 22, **caractérisé en ce que** le signal de sortie du dispositif de calcul de valeur moyenne (TP) est utilisé comme valeur de seuil (SS).

24. Arrangement selon l'une des revendications 21 à 23, **caractérisé en ce que** le dispositif de calcul de valeur moyenne (TP) est désactivé lorsque et tant que le signal numérique (DS) présente un état qui représente le niveau haut.

25. Arrangement selon l'une des revendications 21 à 23, **caractérisé en ce que** le dispositif de calcul de valeur moyenne (TP) est désactivé lorsque et tant que le signal numérique (DS) présente un état qui représente le niveau bas.

26. Arrangement selon la revendication 24 ou 25, **caractérisé en ce que** l'activation et la désactivation du dispositif de calcul de valeur moyenne (TP) s'effectuent en fonction du résultat de la comparaison du signal numérique (DS) avec un courant de référence (Iref) ou une tension de référence.

27. Arrangement selon la revendication 24 ou 25, **caractérisé en ce que** l'activation et la désactivation du dispositif de calcul de valeur moyenne (TP) s'effectuent en fonction des résultats des comparaisons du signal numérique (DS) avec plusieurs courants de référence (Irefi, Irefh) ou tensions de référence.

28. Arrangement selon la revendication 24 ou 25, **caractérisé en ce que** l'activation et la désactivation du dispositif de calcul de valeur moyenne (TP) s'effectuent en fonction de la progression dans le temps des résultats des comparaisons.

29. Procédé de détermination du niveau respectivement actuel d'un signal numérique,
- le signal numérique (DS) étant comparé avec une valeur de seuil (SS), laquelle se trouve entre l'état du signal numérique qui représente le niveau bas et l'état du signal numérique qui représente le niveau haut,
- une valeur de seuil adaptée aux conditions dominantes étant utilisée,
- la valeur de seuil étant définie en tenant compte de la progression dans le temps du signal numérique, et
- l'état du signal numérique qui représente le niveau bas et/ou le niveau haut étant déterminé et la valeur de seuil étant définie en tenant compte du résultat de cette détermination,
**caractérisé en ce que**
la valeur de seuil (SS) est déterminée en multipliant l'état du signal numérique (DS) qui représente le niveau bas et/ou le niveau haut par un facteur donné.

30. Procédé selon la revendication 29, **caractérisé en ce que** la détermination de l'état du signal numérique (DS) qui représente le niveau bas et/ou le niveau haut se compose de la détermination du courant ou de la tension que présente le signal numérique en moyenne lorsqu'un niveau plus bas ou un niveau plus haut est représenté par celle-ci.

31. Procédé selon l'une des revendications 29 ou 30, **caractérisé en ce que** la détermination de l'état du signal numérique (DS) qui représente le niveau bas et/ou le niveau haut est effectuée par un filtre passe-bas (TP).

32. Procédé selon l'une des revendications 29 à 31, **caractérisé en ce que** la partie de l'arrangement (SWG) qui détermine l'état du signal numérique (DS) qui représente le niveau bas est désactivée lorsque et tant que le signal numérique présente un état qui représente le niveau haut.

33. Procédé selon l'une des revendications 29 à 31, **caractérisé en ce que** la partie de l'arrangement (SWG) qui détermine l'état du signal numérique (DS) qui représente le niveau haut est désactivée lorsque et tant que le signal numérique présente un état qui représente le niveau bas.

34. Procédé selon la revendication 32 ou 33, **caractérisé en ce que** l'activation et la désactivation de la partie de l'arrangement (SWG) qui détermine l'état du signal numérique (DS) qui représente le niveau bas ou le niveau haut s'effectuent en fonction du résultat de la comparaison du signal numérique avec un courant de référence (Iref) ou une tension de référence.

35. Procédé selon la revendication 32 ou 33, **caractérisé en ce que** l'activation et la désactivation de la partie de l'arrangement (SWG) qui détermine l'état du signal numérique (DS) qui représente le niveau bas ou le niveau haut s'effectuent en fonction des résultats des comparaisons du signal numérique avec plusieurs courants de référence (Irefl, Irefh) ou tensions de référence.

36. Procédé selon la revendication 34 ou 35, **caractérisé en ce que** l'activation et la désactivation de la partie de l'arrangement (SWG) qui détermine l'état du signal numérique (DS) qui représente le niveau bas ou le niveau haut s'effectuent en fonction de la progression dans le temps des résultats des comparaisons.

37. Procédé selon l'une des revendications 29 à 31, **caractérisé en ce qu'**en amont de la partie de l'arrangement (SWG) qui détermine l'état du signal numérique (DS) qui représente le niveau bas est branché un dispositif (S) qui veille à ce qu'à la partie de l'arrangement qui détermine l'état du signal numérique qui représente le niveau bas soit constamment acheminé un signal qui présente l'état représentant le niveau bas.

38. Procédé selon la revendication 37, **caractérisé en ce que** le dispositif (S) branché en amont est commandé de telle sorte qu'il
- achemine le signal numérique ou un signal correspondant à ce signal à la partie de l'arrangement (SWG) qui détermine l'état du signal numérique (DS) qui représente le niveau bas lorsque et tant que le signal numérique présente l'état qui représente le niveau bas, et
- convertit le signal numérique (DS) en un signal qui présente un état qui représente un niveau bas et achemine ce signal à la partie de l'arrangement (SWG) qui détermine l'état du signal numérique qui représente le niveau bas lorsque et tant que le signal numérique présente l'état qui représente le niveau haut.

39. Procédé selon l'une des revendications 29 à 31, **caractérisé en ce qu'**en amont de la partie de l'arrangement (SWG) qui détermine l'état du signal numérique (DS) qui représente le niveau haut est branché un dispositif (S) qui veille à ce qu'à la partie de l'arrangement qui détermine l'état du signal numérique qui représente le niveau haut soit constamment acheminé un signal qui présente l'état représentant le niveau haut.

40. Procédé selon la revendication 39, **caractérisé en ce que** le dispositif (S) branché en amont est commandé de telle sorte qu'il
- achemine le signal numérique ou un signal correspondant à ce signal à la partie de l'arrangement (SWG) qui détermine l'état du signal numérique (DS) qui représente le niveau haut lorsque et tant que le signal numérique présente l'état qui représente le niveau haut, et
- convertit le signal numérique (DS) en un signal qui présente un état qui représente un niveau haut et achemine ce signal à la partie de l'arrangement (SWG) qui détermine l'état du signal numérique qui représente le niveau haut lorsque et tant que le signal numérique présente l'état qui représente le niveau bas.

41. Procédé selon l'une des revendications 37 à 40, **caractérisé en ce que** la commande du dispositif (S) branché en amont s'effectue en fonction du résultat de la comparaison du signal numérique avec un courant de référence (Iref) ou une tension de référence.

42. Procédé selon l'une des revendications 37 à 40, **caractérisé en ce que** la commande du dispositif (S) branché en amont s'effectue en fonction des résultats des comparaisons du signal numérique avec plusieurs courants de référence (Irefl, Irefh) ou tensions de référence.

43. Procédé selon la revendication 41 ou 42, **caractérisé en ce que** la commande du dispositif (S) branché en amont s'effectue en fonction de la progression dans le temps des résultats des comparaisons.

44. Procédé selon la revendication 29, **caractérisé en ce que** le dispositif de détermination de valeur de seuil contient un dispositif (M, S) par lequel la tension qui représente le niveau haut ou le courant qui représente le niveau haut et/ou la tension qui représente le niveau bas ou le courant qui représente le niveau bas sont converti(e)s en une tension supérieure ou inférieure d'un facteur donné ou en courant supérieur ou inférieur d'un facteur donné.

45. Procédé selon la revendication 44, **caractérisé en ce que** le facteur est choisi de telle sorte qu'au moins des parties de la tension délivrée par le dispositif ou au moins des parties du courant délivré par le dispositif représentent la valeur de seuil (SS) dans le cas d'un signal numérique (DS) auquel ne sont pas superposées des perturbations.

46. Procédé selon la revendication 44 ou 45, **caractérisé en ce que** le facteur est soumis à une variation en fonction du résultat de la comparaison du signal numérique (DS) avec un courant de référence (Iref) ou une tension de référence.

47. Procédé selon la revendication 44 ou 45, **caractérisé en ce que** le facteur est soumis à une variation en fonction du résultat des comparaisons du signal numérique (DS) avec plusieurs courants de référence (Irefl, Irefh) ou tensions de référence.

48. Procédé selon la revendication 46 ou 47, **caractérisé en ce que** le facteur est soumis à une variation en fonction de la progression dans le temps des résultats des comparaisons.

49. Procédé selon l'une des revendications 44 à 48, **caractérisé en ce qu'**en aval du dispositif (M, S) est branché un dispositif de calcul de valeur moyenne (TP) qui calcule la valeur moyenne de la tension qui lui est acheminée ou du courant qui lui est acheminé.

50. Procédé selon la revendication 49, **caractérisé en ce que** le dispositif de calcul de valeur moyenne (TP) est un filtre passe-bas.

51. Procédé selon la revendication 49 ou 50, **caractérisé en ce que** le signal de sortie du dispositif de calcul de valeur moyenne (TP) est utilisé comme valeur de seuil (SS).

52. Procédé selon l'une des revendications 49 à 51, **caractérisé en ce que** le dispositif de calcul de valeur moyenne (TP) est désactivé lorsque et tant que le signal numérique (DS) présente un état qui représente le niveau haut.

53. Procédé selon l'une des revendications 49 à 51, **caractérisé en ce que** le dispositif de calcul de valeur moyenne (TP) est désactivé lorsque et tant que le signal numérique (DS) présente un état qui représente le niveau bas.

54. Procédé selon la revendication 52 ou 53, **caractérisé en ce que** l'activation et la désactivation du dispositif de calcul de valeur moyenne (TP) s'effectuent en fonction du résultat de la comparaison du signal numérique (DS) avec un courant de référence (Iref) ou une tension de référence.

55. Procédé selon la revendication 52 ou 53, **caractérisé en ce que** l'activation et la désactivation du dispositif de calcul de valeur moyenne (TP) s'effectuent en fonction des résultats des comparaisons du signal numérique (DS) avec plusieurs courants de référence (Irefi, Irefh) ou tensions de référence.

56. Procédé selon la revendication 54 ou 55, **caractérisé en ce que** l'activation et la désactivation du dispositif de calcul de valeur moyenne (TP) s'effectuent en fonction de la progression dans le temps des résultats des comparaisons.
